Europäisches Patentamt

European Patent Office

Office européen des brevets

(19)

(11) Veröffentlichungsnummer: **0 269 827 B1**

## (12) EUROPÄISCHE PATENTSCHRIFT

(45) Veröffentlichungstag der Patentschrift: **22.12.93**

(21) Anmeldenummer: **87115463.9**

(22) Anmeldetag: **22.10.87**

(51) Int. Cl.5: **G01R 19/25**, G01R 21/133, G01R 19/02

(54) **Digitales Messgerät.**

(30) Priorität: **04.11.86 CH 4361/86**

(43) Veröffentlichungstag der Anmeldung:
**08.06.88 Patentblatt 88/23**

(45) Bekanntmachung des Hinweises auf die
Patenterteilung:
**22.12.93 Patentblatt 93/51**

(84) Benannte Vertragsstaaten:
**CH DE LI SE**

(56) Entgegenhaltungen:
**EP-A- 0 063 402
DE-A- 3 045 033
DE-A- 3 338 193
DE-A- 3 437 303**

**IECON'85 PROCEEDINGS, INTERNATIONAL
CONFERENCE ON INDUSTRIAL ELECTRO-
NICS, CONTROL AND INSTRUMENTATION,
San Francisco, California, 18.-22. November
1985, Band 2, Seiten 722-728, IEEE, New York,
US; G. ROY et al.: "A variable frequency
power displacement factor measurement
technique using a constant phase filter"**

(73) Patentinhaber: **BBC Brown Boveri AG
Haselstrasse
CH-5401 Baden(CH)**

(72) Erfinder: **Brand, Klaus-Peter, Dr.
Rebhaldenstrasse 12
CH-5430 Wettingen(CH)**
Erfinder: **Kopainsky, Jürgen, Dr.
Sommerhaldenstrasse 4a
CH-5200 Brugg(CH)**
Erfinder: **Wittwer, Fritz
Schöneggstrasse 8c
CH-5300 Turgi(CH)**

EP 0 269 827 B1

MEASUREMENT TECHNIQUES, Band 27, Nr. 6, Juni 1984, Seiten 532-535, Plenum Publishing Corp., New York, US; M.YA. MINTS et al.: "Digital methods for measuring asymmetry of three-phase voltage systems"

REGELUNGSTECHNISCHE PRAXIS, Band 24, Nr. 6, Juni 1982, Seiten 197-202, München, DE; A.H. YANG et al.: "Digitale Drehstrom-Messeinheit"

TECHNISCHE MITTEILUNGEN AEG-TELEFUNKEN, Band 68, Nr. 6/7, 1978, Seiten 291-295, Berlin, DE; H. Hermes: "Mikroprozessoren als Basis für Steuer- und Auswertesysteme in der automatischen Messtechnik"

**Beschreibung**

Technisches Gebiet

Bei der Erfindung wird ausgegangen von einem digitalen Messgerät gemäss dem einleitenden Teil von Patentanspruch 1.

Stand der Technik

Eine dem digitalen Messgerät der vorstehend genannten Art vergleichbare Anordnung zur Bestimmung der zeitlichen Mittelwerte analoger Messwerte sinusförmiger periodischer Grössen, wie Effektivwert, Wirk-, Blind- oder Scheinleistung, sowie zeitabhängiger Fourierkoeffizienten nichtsinusförmiger periodischer Grössen in einem Wechselstromnetz ist in DE-A-3 045 033 beschrieben. In dieser Anordnung werden die analogen Messwerte zunächst digitalisiert und aus den digitalisierten Messwerten nachfolgend in einer Schieberegister, Addierer und Faktorbildner enthaltenden Schaltung die zeitlichen Mittelwerte der Messwerte sowie die zeitabhängigen Fourierkoeffizienten bestimmt. Hierbei wird in einem ersten Addierer und einem nachgeschalteten Faktorbildner aus zwei aufeinanderfolgenden Messignalen ein Korrekturwert ermittelt, welcher in einem einen zweiten Addierer und ein Schieberegister enthaltenden Teil der Schaltung zum Mittelwert des Messwertes bzw. zum zeitabhängigen Fourierkoeffizienten integriert wird. Bei diesem Messgerät ist die Genauigkeit der zeitlichen Mittelwerte und der zeitabhängigen Fourierkoeffizienten wesentlich bestimmt durch die Güte der aus den aufeinanderfolgenden Messwerten ermittelten Korrekturwerte.

In IEEE TRANSACTIONS ON INSTRUMENTATION AND MEASUREMENT, Vol. IM-27, Nr.4, December 1978, Seiten 368-372; B.F.FIELD: "A Fast Response Low-Frequency Voltmeter" ist ein den Effektivwert und die Wellenform von Spannungen im Frequenzbereich zwischen 0,1 und 120 Hz ermittelndes digitales Messgerät beschrieben. Dieses Messgerät enthält einen Mikrocomputer mit voneinander unabhängigen Funktionsblöcken, in dem digitalisierte Messignale zur Ermittlung des Effektivwertes und der Wellenform verarbeitet werden. Bei der Ermittlung des Effektivwertes werden hierbei die Messignale über eine Periode der Spannung numerisch integriert. Bei der Ermittlung der Wellenform werden die diskreten Koeffizienten einer Fouriertransformation mittels einer schnellen Fourieranalyse berechnet.

Ein weiteres digitales Messgerät ist bekannt aus J. Weiler: Begriffe und Methoden der Signalbeschreibung und Signalverarbeitung. Bull. SEV/VSE 72 (1982) 9, S. 433-438. Bei diesem Messgerät werden analoge Ausgangssignale eines elektrischen Versorgungsnetzes, etwa der Strom oder die Spannung einer Netzphase an diskreten Zeitpunkten abgetastet, die abgetasteten Signale digitalisiert und nachfolgend zu einer netzspezifischen Grösse, wie etwa dem Effektivwert oder der Wirkleistung, digital weiterverarbeitet. Ein derartiges Messgerät ist üblicherweise zur optimierten Lösung einer einzelnen Messwertverarbeitungsaufgabe, wie etwa der Bestimmung des Effektivwertes oder der Wirkleistung, ausgelegt und nutzt die Dreiphasennatur des elektrischen Versorgungsnetzes nicht aus, wodurch die Zahl der von einem solchen Messgerät lösbaren Messwertverarbeitungsaufgaben erheblich eingeschränkt ist. Zudem ist ein solches Messgerät nur zur Verarbeitung von Signalen mit vergleichsweise geringem Oberwellengehalt geeignet, so dass für Netze mit erheblichem Oberwellengehalt spezielle Messgeräte eingesetzt werden müssen. Ferner benötigt das bekannte Messgerät einen analogen Tiefpass zur Vermeidung unerwünschter Aliasfrequenzen, welche bei der Abtastung der Ausgangssignale auftreten. Ein solcher analoger Tiefpass ist nicht nur aufwendig, sondern senkt entweder die Genauigkeit im Durchgangsbereich oder erhöht die unerwünschte Durchlässigkeit im Sperrbereich.

Darstellung der Erfindung

Die Erfindung, wie sie in den Patentansprüchen gekennzeichnet ist, löst die Aufgabe, ein digitales Messgerät der eingangs genannten Art anzugeben, welches bei einfachem Aufbau und projektierbarer Messgenauigkeit zur Lösung aller wichtigen Messwertverarbeitungsaufgaben eines elektrischen Versorgungsnetzes geeignet ist.

Das digitale Messgerät nach der Erfindung zeichnet sich dadurch aus, dass ein analoges Filter zur Vermeidung von Aliasfrequenzen entfällt, dass alle wichtigen Messwertverarbeitungsaufgaben auf der Basis einer einheitlichen Struktur gelöst werden können, dass die Dreiphasennatur des elektrischen Netzes konsequent ausgenützt wird und dass es in symmetrisch und unsymmetrisch belasteten sowie in oberwellenbehafteten Netzen verwendbar ist.

EP 0 269 827 B1

Kurze Beschreibung der Zeichnungen

Nachfolgend wird die Erfindung anhand eines in Zeichnungen dargestellten Ausführungsbeispiels näher erläutert. Hierbei zeigt:

Fig. 1 ein Prinzipschaltbild eines in einem elektrischen Versorgungsnetz eingesetzten digitalen Messgerätes nach der Erfindung,

Fig. 2 eine Schaltung einer digitalen Verarbeitungseinheit des Messgerätes gemäss Fig. 1 zur Ermittlung des Effektivwertes, des Effektivwertes der n-ten Harmonischen sowie des Klirrfaktors einer Phase des Versorgungsnetzes,

Fig. 3 eine Schaltung der digitalen Verarbeitungseinheit des Messgerätes gemäss Fig. 1 zur Ermittlung der Wirk- und Blindleistung des Versorgungsnetzes,

Fig. 4 eine Schaltung der digitalen Verarbeitungseinheit des Messgerätes gemäss Fig. 1 zur Ermittlung der Frequenz des Versorungsnetzes,

Fig. 5 eine Schaltung der digitalen Verarbeitungseinheit des Messgerätes gemäss Fig. 1 zur Ermittlung der Mitkomponente, der Gegenkomponente und des Asymmetrieverhältnisses, und

Fig. 6 eine Schaltung der digitalen Verarbeitungseinheit des Messgerätes gemäss Fig. 1 zur Ermittlung der Nullkomponente.

Weg zur Ausführung der Erfindung

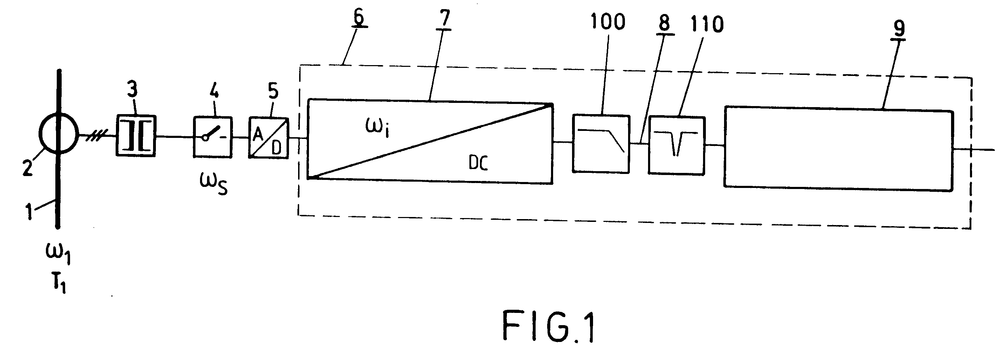

In Fig. 1 bezeichnet 1 einen dreiphasigen Leiter eines elektrischen Versorgungsnetzes, in dem ein dreiphasiger Strom der Nennkreisfrequenz $\omega_1$ fliesst. Die Werte der Phasenströme und/oder -spannungen des Leiters 1 des Versorgungsnetzes werden über Strom- und Spannungswandler 2 sowie gegebenenfalls vorgesehene Zwischenwandler 3 dem Eingang einer Abtast- und Halte-Schaltung 4 des digitalen Messgerätes nach der Erfindung zugeführt. In der Abtast- und Halte-Schaltung 4 werden die Phasenströme und/oder -spannungen mit einer vorgegebenen Abtastfrequenz $\omega_S$ abgetastet und zwischengespeichert. In einem der Abtast- und Halte-Schaltung 4 nachgeschalteten Analog-Digital-Wandler 5 werden die abgetasteten und zwischengespeicherten Werte der Phasenströme und/oder -spannungen digitalisiert und nachfolgend einer digitalen Verarbeitungseinheit 6 zugeführt, in der sie zur Lösung der in elektrischen Versorgungsnetzen auftretenden Messwertverarbeitungsaufgaben, wie der Bestimmung des Effektivwertes, des Effektivwertes der n-ten Harmonischen und des Klirrfaktors von Strom und/oder Spannung einer Phase, der Wirk- und Blindleistung, der Frequenz, der Mit- und/oder Gegenkomponente, des Asymmetrieverhältnisses und der Nullkomponente des Versorgungsnetzes verarbeitet werden.

Die digitale Verarbeitungseinheit 6 weist einen Umwandlungsblock 7 auf, in dem die während einer Periode $T_1$ des Stromes oder der Spannung des Versorgungsnetzes von der Abtast- und Halte-Schaltung 4 abgetasteten und vom Analog-Digital-Wandler 5 abgegebenen, aus einer Grundwelle der Nennkreisfrequenz 1 sowie Oberwellen der Frequenzen i, i = 2, 3,.., n, bestehenden Messsignale umgewandelt werden in ein Gleichsignal DC, welches für die Lösung einer zugeordneten Messwertverarbeitungsaufgabe spezifisch ist. In einer dem Umwandlungsblock 7 nachgeschalteten Filteranordnung 8 werden vom Gleichsignal DC abweichende störende Frequenzen unterdrückt, in einen digitalen Tiefpass 100 die Harmonischen und in einer dem Tiefpass 100 nachgeschalteten Bandsperre 110 die bei der Abtastung mit der Abtast- und Halte-Schaltung 4 gebildeten Aliasfrequenzen. In einer der Filteranordnung 8 nachgeschalteten Verarbeitungsvorrichtung 9 werden schliesslich die Umgewandelten und gefilterten Gleichsignale DC nach Massgabe der zu lösenden Messwertverarbeitungsaufgabe verarbeitet und nachfolgend als zu bestimmende netzspezifische Grösse ausgegeben.

Ein derartig aufgebautes Messgerät zeichnet sich dadurch aus, dass es alle in einem elektrischen Versorgungsnetz zu lösenden Messwertverarbeitungsaufgaben auf der Grundlage einer aus Umwandlungsblock 7, Filteranordnung 8 und Verarbeitungsvorrichtung 9 bestehenden, einheitlich aufgebauten digitalen Verarbeitungseinheit 6 löst. Wie nachfolgend erläutert, kann eine solche digitale Verarbeitungseinheit 6 vorzugsweise aus einem Basissatz geläufiger, in Programmbibliotheken verfügbarer Funktionsblöcken aufgebaut sein. Aufwendige analoge Anti-Aliasing-Filter welche sonst Grundvoraussetzung für eine genaue Lösung der Messwertverarbeitungsaufgaben in elektrischen Netzen sind, können entfallen. Darüber hinaus lässt sich ein solches Messgerät unter konsequenter Ausnützung der Dreiphasennatur eines elektrischen Versorgungsnetzes sowohl in symmetrisch als auch in unsymmetrisch belasteten Netzen einsetzen. Hierbei wird die grösste auswertbare Oberwelle im wesentlichen lediglich durch die Abtastrate der Abtast- und Halte-Schaltung 4, die Bandbreite der verarbeiteten Signale und die Auflösung des Analog-Digital-Wandlers 5 begrenzt.

4

Der Basissatz der Funktionsblöcke enthält hierbei zweckmässigerweise mindestens einen Summierer, einen Summierer mit Konstantfaktormultiplikation, einen Multiplizierer, einen Dividierer, einen Radizierer, einen Mittelwertbildner, einen PI-Regler, einen Koordinatenwandler, einen Signalgenerator und einen Funktionsblock zur Lösung einer Differenzengleichung zweiter Ordnung.

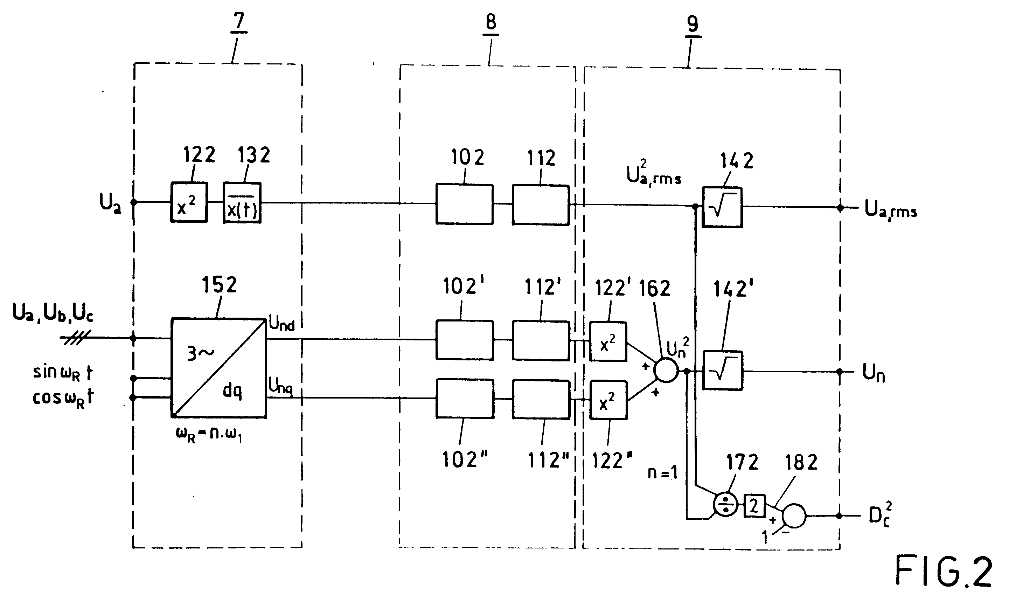

In den Figuren 2 bis 6 sind nun aus derartigen Funktionsblöcken bestehende Schaltungen der digitalen Verarbeitungseinheit 6 dargestellt, welche in einfacher Weise die Lösung aller Messwertverarbeitungsaufgaben in elektrischen Versorgungsnetzen mit hoher Genauigkeit ermöglichen.

Mit der in Fig. 2 dargestellten Schaltung kann der Effektivwert $U_{a,rms}$ der Phasenspannung $U_a$ des Versorgungsnetzes ermittelt werden sowie entsprechend der Effektivwert $U_n$ der n-ten Harmonischen und der Klirrfaktor $D_c$. Entsprechendes gilt auch für die anderen Phasen S und T sowie für die Phasenströme.

Die dargestellte Schaltung enthält im Umwandlungsblock 7 einen als Quadrierer ausgebildeten Multiplizierer 122, an dessen Eingang die digitalisierten Werte der Spannung $U_a$ der Phase R des Versorgungsnetzes anstehen, sowie einen dem Multiplizierer 122 nachgeschalteten Mittelwertbildner 132, dessen Ausgang über einen Tiefpass 102 und eine Bandsperre 112 der Filteranordnung 8 auf den Eingang eines Radizierers 142 der Verarbeitungsvorrichtung 9 wirkt. Am Ausgang des Radizierers 142 tritt ein dem Effektivwert der Spannung der Phase R proportionales Signal auf.

Darüber hinaus enthält die in Fig. 2 dargestellte Schaltung im Umwandlungsblock 7 auch einen RST-dq-Koordinatenwandler 152, an dessen Eingängen die den drei Phasen R, S, T des Versorgungsnetzes zugeordneten digitalisierten Signale der Spannung $U_a$, $U_b$, $U_c$ anstehen sowie Referenzsignale $\sin\omega_R t$ und $\cos\omega_R t$, mit $\omega_R = n\omega_1$, wobei n = 1, 2, ..., welche repräsentativ für einen zeitveränderlichen Winkel $\epsilon$ zwischen dem RST- und dem dq-Koordinatensystem sind. Ein am Ausgang für die direkte Koordinate des RST-dq-Koordinatenwandlers 152 auftretendes Signal $U_{nd}$ wirkt über einen Tiefpass 102' und eine Bandsperre 112' auf einen als Quadrierer ausgeführten Multiplizierer 122'. Ein am quadratischen Ausgang des RST-dq-Koordinatenwandlers 152 auftretendes Signal $U_{nq}$ wirkt über einen Tiefpass 102'' und eine Bandsperre 112'' auf einen ebenfalls als Quadrierer ausgebildeten Multiplizierer 122''. Die Ausgänge der beiden Multiplizierer 122' und 122'' sind jeweils mit dem Eingang eines Summierers 162 verbunden, dessen Ausgang mit dem Eingang eines Radizieres 142' verbunden ist, an dessen Ausgang ein dem Effektivwert $U_n$ der Phasenspannung proportionales Signal auftritt.

Falls der Winkel zwischen dem RST- und dem dq-Koordinatensystem gleich $w_1 t$ ist wirkt der Ausgang des Summierers 162 auch auf einen ersten Eingang eines Dividierers 172, dessen zweitem Eingang ein Eingangssignal des Radizierers 142 zugeführt ist. Der Ausgang des Dividierers 172 wirkt auf einen ersten Eingang eines Summierers mit Konstantfaktormultiplikation 182, dessen zweitem Eingang das Signal -1 zugeführt wird und dessen Ausgang ein dem Quadrat des Klirrfaktors $D_c$ proportionales Signal abgibt.

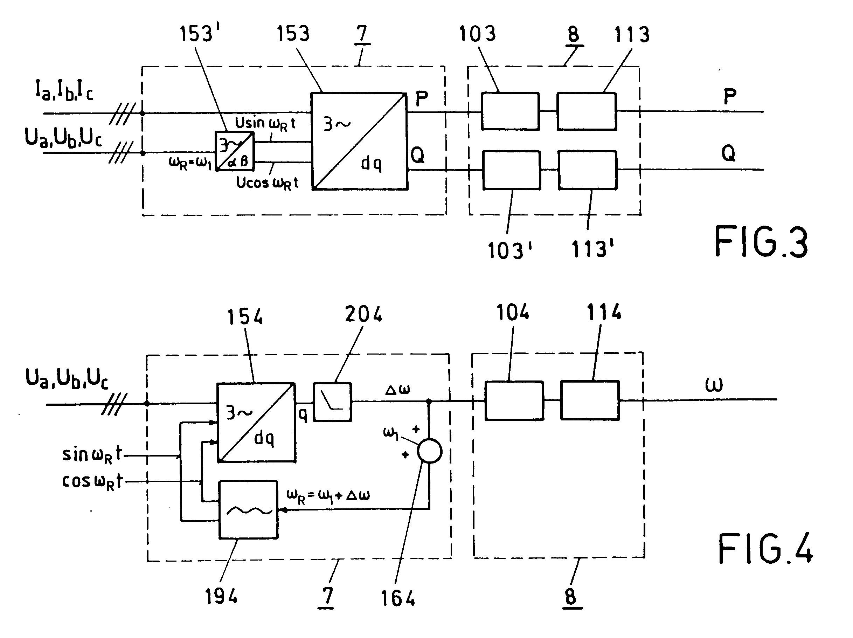

Mit der in Fig. 3 dargestellten Schaltung Können die Wirkleistung P und die Blindleistung Q des elektrischen Versorgungsnetzes bei Abwesenheit von Nullkomponenten bestimmt werden. Die dargestellte Schaltung enthält im Umwandlungsblock 7 einen RST-dq-Koordinatenwandler 153, an dessen Eingängen die den drei Phasen R, S, T des elektrischen Versorgungsnetzes zugeordneten digitalisierten Stromwerte $I_a$, $I_b$ und $I_c$ anliegen sowie als Referenzignale verwendete Ausgangssignale $U \cdot \sin\omega_R t$ und $U \cdot \cos\omega_R t$ eines RST-$\alpha,\beta$-Koordinatenwandlers 153', an dessen Eingängen die den drei Phasen R, S, T des Versorgungsnetzes zugeordneten Spannungssignale $U_a$, $U_b$, $U_c$ anliegen. Der Ausgang des RST-dq-Koordinatenwandlers 153 für die direkte Koordinate gibt über einen Tiefpass 103 und eine Bandsperre 113 der Filteranordnung 8 ein die Wirkleistung P repräsentierendes Ausgangssignal ab. Der Ausgang des RST-dq-Koordinatenwandlers 153 für die quadratische Koordinate gibt über einen Tiefpass 103' und eine Bandsperre 113' ein die Blindleistung Q repräsentierendes Ausgangssignal ab.

Mit der in Fig. 4 dargestellten Schaltung kann die Netzfrequenz $\omega$ des elektrischen Versorgungsnetzes ermittelt werden. Die dargestellte Schaltung enthält im Umwandlungsblock 7 einen RST-dq-Koordinatenwandler 154, an dessen Eingängen die den drei Phasen des Versorgungsnetzes zugeordneten digitalisierten Spannungswerte $U_a$, $U_b$, $U_c$ anliegen sowie als Referenzsignale verwendete Ausgangssignale $\sin\omega_R t$ und $\cos\omega_R t$ eines als VCO wirkenden Signalgenerators 194. Der für die quadratische Koordinate vorgesehene Ausgang q des RST-dq-Koordinatenwandlers 154 ist dem Eingang eines als Schleifenfilter wirkenden PI-Reglers 204 zugeführt. Ein am Ausgang des PI-Reglers 204 anstehendes Signal $\Delta\omega$ ist einerseits über einen Tiefpass 104 und eine Bandsperre 114 der Filteranordnung 8 an einen Ausgang des digitalen Messgerätes geführt, welcher ein der Netzfrequenz $\omega$ des Versorgungsnetzes proportionales Signal abgibt, und andererseits an einem ersten Eingang eines Summierers 164, dessen zweitem Eingang ein der Nennkreisfrequenz $\omega_1$ des Versorgungsnetzes proportionales Signal zugeführt ist, und dessen Ausgangssignal $\omega_R = \omega_1 + \Delta\omega$ auf einen Eingang des Signalgenerators 194 wirkt.

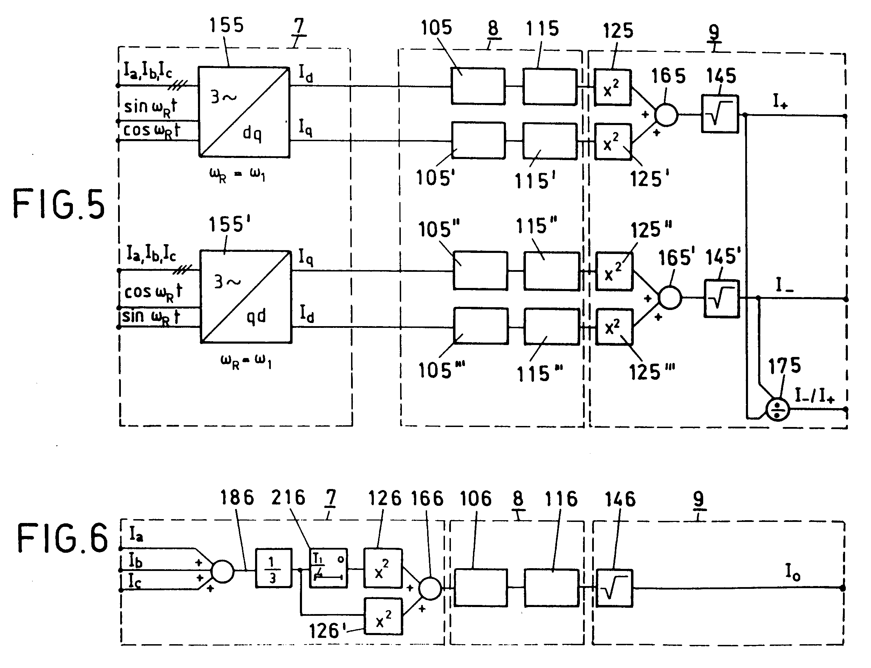

Mit der in Fig. 5 dargestellten Schaltung können die Mitkomponente $I_+$, die Gegenkomponente $I_-$ und das Asymmetrieverhältnis $I_-/I_+$ des elektrischen Versorgungsnetzes bestimmt werden.

Die dargestellte Schaltung enthält im Umwandlungsblock 7 einen ersten RST-dq-Koordinatenwandler 155, an dessen Eingängen die den drei Phasen des Versorgungsnetzes zugeordneten digitalisierten Stromwerter $I_a$, $I_b$ und $I_c$ anstehen sowie Referenzsignale $\sin\omega_R t$ und $\cos\omega_R t$, mit $\omega_R = \omega_1$, welche repräsentativ sind für einen zeitveränderlichen Winkel $\omega_1 t$ zwischen dem RST und dem dq-Koordinatensystem. Ein am Ausgang des RST-dq-Koordinatenwandlers 155 für die direkte Koordinate anstehendes und der direkten Stromkomponente $I_d$ proportionales Signal wirkt über einen Tiefpass 105 und eine Bandsperre 115 der Filteranordnung 8 auf einen als Quadrierer ausgebildeten Multiplizierer 125 der Verarbeitungsvorrichtung 9. Der Ausgang des Multiplizierers 125 ist mit einem ersten Eingang eines Summierers 165 verbunden. Ein am Ausgang des RST-dq-Koordinatenwandlers 155 für die quadratische Koordinate anstehendes und der quadratischen Stromkomponente $I_q$ proportionales Signal wirkt über einen Tiefpass 105' und eine Bandsperre 115' der Filteranordnung 8 auf einen als Quadrierer ausgebildeten Multiplizierer 125' der Verarbeitungsvorrichtung 9. Der Ausgang des Multiplizierers 125' ist mit dem zweiten Eingang des Summierers 165 verbunden. Am Ausgang des Summierers 165 tritt ein dem Quadrat der Mitkomponente $I_+$ proportionales Signal auf, welches in einem nachgeschalteten Radizierer 145 der Verarbeitungsvorrichtung 9 radiziert wird.

Im Umwandlungsblock 7 ist ferner ein RST-qd-Koordinatenwandler 155' vorgesehen, an dessen Eingängen entsprechend dem RST-dq-Koordinatenwandler 155 die Signale $I_a$, $I_b$, $I_c$ anliegen sowie Referenzsignale $\sin\omega_R t$ und $\cos\omega_R t$. Ein am Ausgang des RST-qd-Koordinatenwandlers 155' für die quadratische Koordinate anstehende und der quadratischen Stromkomponente $I_q$ proportionales Signal wirkt über einen Tiefpass 105'' und eine Bandsperre 115'' der Filteranordnung 8 auf einen als Quadrierer ausgebildeten Multiplizierer 125'' der Verarbeitungseinrichtung 9. Der Ausgang des Multiplizierers 125'' ist mit einem ersten Eingang eines Summierers 165' verbunden. Ein am Ausgang des RST-qd-Koordinatenwandlers 155' für die direkte Koordinate anstehendes und der direkten Stromkomponente $I_d$ proportionales Signal wirkt über einen Tiefpass 105''' und eine Bandsperre 115''' der Filteranordnung 8 auf einen als Quadrierer ausgebildeten Multiplizierer 125'''. Der Ausgang des Multiplizierers 125''' ist mit dem zweiten Eingang des Summierers 165' verbunden. Am Ausgang des Summierers 165' tritt ein dem Quadrat der Gegenkomponente $I_-$ proportionales Signal auf, welches in einem nachgeschalteten Radizierer 145' der Verarbeitungseinheit 9 radiziert wird.

Zur Ermittlung des Asymmetrieverhältnisses $I_-/I_+$ weist die Schaltung gemäss Fig. 5 einen eingangsseitig mit den Ausgängen der Radizierer 145 und 145' verbundenen Dividierer 175 auf.

Die in Fig. 6 dargestellte Schaltung enthält im Umwandlungsblock 7 eine Schaltungsanordnung, welche gebildet ist von einem Summierer mit Konstantfaktormultiplikation 186, zwei jeweils als Quadrierer ausgebildeten Multiplizierern 126 und 126', einem Verzögerungsglied 216 mit einer Zeitverzögerung von 1/4 der Periode $T_1$ des Versorgungsnetzes und einem Summierer 166. Bei dieser Schaltung stehen an den Eingängen des Summierers mit Konstantfaktormultiplikation 186 die den Phasenströmen $I_a$, $I_b$ und $I_c$ proportionalen digitalen Signale an. Der Ausgang des Summierers mit Konstantfaktormultiplikation 186 ist einerseits über den Multiplizierer 126' mit einem ersten Eingang des Summierers 166 und andererseits über das Verzögerungsglied 216 und den dem Verzögerungsglied 216 nachgeschalteten Multiplizierer 126 mit einem zweiten Eingang des Summierers 166 verbunden. Der Ausgang des Summierers 166 wirkt über einen Tiefpass 106 und eine Bandsperre 116 der Filteranordnung 8 auf einen in der Verarbeitungsvorrichtung 9 vorgesehenen Radizierer 146, an dessen Ausgang ein der Nullkomponente $I_o$ proportionales Signal ansteht.

Die in den vorstehenden Schaltungen vorgesehenen Tiefpässe 100, 102, 102', 102'', 103, 103', 104, 105, 105', 105'', 105''' und 106, Bandsperren 110, 112, 112', 112'', 113, 113', 114, 115, 115', 115'', 115''' und 116 und das Verzögerungsglied 216 weisen jeweils einen die Differenzengleichung

$$G(z) = \frac{a_o + a_1 z^{-1} + a_2 z^{-2}}{1 + b_1 z^{-1} + b_2 z^{-2}}$$

berechnenden Funktionsblock auf.

Ein solcher Funktionsblock weist Eingänge auf zur Eingabe der Koeffizienten $a_o$, $a_1$, $a_2$, $b_1$ und $b_2$ sowie einer an diskreten Zeitpunkte 1, 2, ... gemessenen Eingangsgrösse $i(k)$, $k = 1, 2, ...$ Dieser Funktionsblock ermittelt zum Zeitpunkt k eine Ausgangsgrösse $o(k)$ nach folgender Gleichung:

$$o(k) = -b_1 o(k-1) - b_2 o(k-2) + a_o i(k) + a_1 i(k-1) + a_2 i(k-2),$$

wobei o(k-1) bzw. i(k-1) die zum Zeitpunkt k-1 bzw.

o(k-2) bzw. i(k-2) die zum Zeitpunkt k-2

ermittelten Werte von o bzw. i sind.

Je nach Wahl der Eingabegrösse lässt sich ein solcher Funktionsblock den an ihn gestellten Anforderungen entsprechend programmieren.

Für die Tiefpässe wird eine z-Transformation verwendet und $z^{-1} = \exp(-sT_s)$ gesetzt.Für die Koeffiziente werden folgende Werte eingegeben:

$a_o = 0$

$a_1 = \omega_o T_s \sqrt{2} \exp(^-\omega_o T_s/ \sqrt{2}) \cdot \sin(\omega_o T_s/ \sqrt{2})$

$a_2 = 0$

$b_1 = - 2 \exp(-\omega_o T_s) \cdot \cos(\omega_o T_s/ \sqrt{2})$, und

$b_2 = \exp(-\omega_o T_s \sqrt{2})$.

Hierbei bedeuten

$T_s$ die Abtastperiode der Abtast- und Halte-Schaltung 4 und s die Variable der Uebertragungsfunktion

$$H(s) = \frac{1}{1 + 2\,\xi s/\omega_o + (s/\omega_o)2}$$

$$= \frac{1}{s + \frac{\omega o}{\sqrt{2}}(1 - j)} + \frac{1}{s + \frac{\omega o}{\sqrt{2}}(1 + j)}$$

eines Tiefpasses zweiter Ordnung mit einem Dämpfungskoeffizienten $\xi = 1/\sqrt{2}$ und einer Grenzfrequenz $\omega_o$.

Solche Tiefpässe unterdrücken die vom Gleichsignal DC abweichenden Frequenzen, wie die Harmonischen $\omega_i$ mit i = 1, 2, ...

Für die Bandsperren wird eine bilineare z-Transformation verwendet,

$$s = \frac{2}{T_s} \cdot \frac{1-z^{-1}}{1+z^{-1}}$$

Für die Koeffizienten werden folgende Werte eingegeben:

$$a_o = a_2 = \frac{1 + 4(T_{br} + T_s)^2}{1 + 4\,\xi T_{br}/T_s + 4(T_{br}/T_s)^2}$$

$$a_1 = b_1 = 2\,\frac{1 - 4(T_{br}/T_s)^2}{1 + 4\,\xi T_{br}/T_s + 4(T_{br}/T_s)^2}$$

$$b_2 = \frac{1 - 4\,\xi T_{br}/T_s + 4(T_{br}/T_s)^2}{1 + 4\,\xi T_{br}/T_s + 4(T_{br}/T_s)^2}$$

Hierbei bedeuten

$T_s$ die Abtastperiode der Abtast- und Halte-Schaltung mit der Abtastfrequenz $\omega_s$,

$T_{br} = 2\pi/\Delta\omega = 2\pi(k\omega_1-\omega_s)$ mit $k = \pm 1, \pm 2, ...$ und s die

Variable der Uebertragungsfunktion.

$$H(s) = \frac{1 + (s/\Delta\omega)^2}{1 + 2\xi s/\Delta\omega + (s/\Delta\omega)^2}$$

eines Filters zweiter Ordnung mit dem Dämpfungskoeffizienten $\xi$. Solche Bandsperren unterdrücken die niedrigste Aliasfrequenz, die im allgemeinen die grösste Amplitude aufweist.

Entsprechend sind auch die Multiplizierer 122, 122', 122'', 126 und 126' jeweils aus einem Funktionsblock eines geläufigen Typs gebildet. Entsprechendes gilt auch für den Mittelwertbildner 132, die Radizierer 142, 142', 145, 145' und 146, die Summierer 162, 164, 165, 165' und 166, die Dividierer 172 und 175, die Summierer mit Konstantfaktormultiplikation 182 und 186, den Signalgenerator 194 und den PI-Regler 204.

Die RST-dq- bzw.-$\alpha\beta$-Koordinatenwandler 152, 153, 153', 154 und 155 sowie der RST-qd-Koordinatenwandler 155' sind jeweils von einem Funktionsblock gebildet, welcher die R,S,T-Werte eines 3-Phasen-System in entsprechende Werte im orthogonalen d,q- bzw. im $\alpha, \beta$-Koordinatensystem transformiert. Der Winkel $\epsilon$ zwischen den beiden Koordinatensystemen wird hierbei zugleich so fest gelegt, dass die Werte der R,S,T-Koordinaten in entsprechende Werte im orthogonalen $\alpha, \beta$-Koordinatensystem transformiert sind. In diesem Fall fällt die $\alpha$-Koordinate mit der R-Koordinate zusammen und gilt für die Transformation das Gleichungssystem:

$\alpha = R$
$\beta = (1/\sqrt{3})S-(1/\sqrt{3})T$
$d = \alpha \cdot \cos\epsilon + \beta\sin\epsilon$
$q = -\alpha \cdot \sin\epsilon + \beta\cos\epsilon$

Dem Funktionsblock werden die Werte der Koordinaten R (und damit auch $\alpha$,S,T eingegeben sowie $\sin\epsilon$ und $\cos\epsilon$. Der Funktionsblock ermittelt dann die entsprechenden Werte in $\alpha, \beta$,- bzw. dq-Koordinaten. Bei rotierendem R,S,T-Koordinatensystem rotiert auch das $\alpha, \beta$,-System, wohingegen bei geeigneter Eingabe des Winkels $\epsilon$ (nämlich als Sinus und Cosinus) das da-Koordinatensystem ruht und ein Gleichstromsignal liefert.

Die Transformation von R,S,T- in $\alpha, \beta$,- bzw. da-Koordinaten ist in der Elektrotechnik geläufig und beispielsweise aus dem Taschenbuch der Elektrotechnik, Band 2, Starkstromtechnik, E. Philippow, VEB-Verlag Technik, Berlin, 1966, insbesondere Seite 54 - 60, bekannt.

Die Wirkung des Messgerätes nach Erfindung ist wie folgt:

Die etwa während einer Periode $T_1$ des Versorgungsnetzes von der Abtast- und Halte-Schaltung 4 erfassten und zwischengespeicherten digitalen Werte des Stromes und/oder der Spannung einer oder mehrerer Phasen des Leiters 1 des Versorgungsnetzes werden im Umwandlungsblock 7 von einem harmonische Schwingungen der Frequenzen $\omega_i$, $i = 1, 2, ...$, zu einem zur erwünschten netzspezifischen Grösse proportionalen Gleichsignal DC Umgewandelt. Wie aus den Schaltungen der Fig. 2 bis 6 ersichtlich ist, weist der Umwandlungsblock 7 für jede Messwertverarbeitungsaufgabe einen spezifischen Aufbau auf. Von 0 abweichende harmonische Frequenzen werden vom Tiefpass 100 der Filteranordnung 8 zurückgehalten, durch Abtastung mit der Abtast- und Halte-Schaltung 4 entstehende störende Aliasfrequenzen durch die Bandsperre 110 der Filteranordnung 8. Das gefilterte Gleichsignal DC wird nachfolgend schliesslich in der Verarbeitungsvorrichtung 9 entsprechend der zu lösenden Messwertverarbeitungsaufgabe unter Zuhilfenahme der vier Grundrechnungsarten sowie des Radizierens zur erüünschten netzspezifischen Grösse weiter verarbeitet.

Bei der Schaltung gemäss Fig. 2 ergibt sich die Verschiebung des im Umwandlungsblock verarbeiteten Signals zum Gleichsignal bei der Bestimmung des Effektivwertes von Phasenstrom oder Phasenspannung dadurch, dass für jede Harmonische $\cos(k\omega_1 + \phi k)$, $k = 1, 2, ...$, zur Grundfrequenz $\omega_1$ des Versorgungsnetzes die Identität gilt:

$$\cos^2(\omega_1 t + \varphi_k) = \frac{1}{2} - \cos 2(k\omega_1 t + \varphi_k)$$
$$= DC - \cos 2(k\omega_1 t + \varphi_k)$$

mit $k = 1, 2, \ldots$ und $\phi_k$ als Phasenwinkel.

Jede Harmonische wird also in ein Gleichsignal DC und ein Signal mit doppelter Frequenz aufgespalten. Da der Effektivwert, beispielsweise der Spannung der Phase R, wie folgt definiert ist:

$$U_{a,rms}^2 = \lim_{T \to \infty} \frac{1}{T} \int_{-T/2}^{T/2} U_a(t)dt \, ,$$

verschwinden während der Integration über eine Periode $T_1$ des Versorgungsnetzes die periodischen Terme $2k\omega_1$ ebenso wie die Produkte zwischen den Harmonischen verschiedener Ordnung. Eine Frequenzverschiebung zum Gleichsignal lässt sich daher in einfacher Weise durch Quadrieren der während einer Periode $T_1$ des Versorgungsnetzes erfassten und dem Frequenzverschiebungsblock 7 zugeführten Werte des Eingangssignals sowie durch nachfolgende Mittelwertbildung der quadrierten Werte erreichen.

Bei der Ermittlung des Effektivwertes der n-ten Harmonischen werden durch Transformation des R,S,T-Koordinatensystem in das dq-Koordinatensystem Gleichsignale für die direkte und die quadratische Komponente der n-ten Harmonischen erreicht. Für die Phasenspannung $U_a$ erhält man daher an den Ausgängen des R,S,T-dq-Koordinatenwandlers 152 Gleichspannungssignale $U_{nd}$ und $U_{nq}$, welche nach Filtern, Quadrieren, Summieren und Radizieren in einfacher Weise den gewünschten Effektivwert liefern.

$$U_n = \sqrt{U_{cn}^2 + U_{sn}^2} = \sqrt{U_{nd}^2 + U_{nq}^2}$$

mit

$$U_{cn} = \lim_{T \to \infty} \frac{1}{T} \int_{-T/2}^{T/2} U_a(t) \cos n\omega_1 dt \quad \text{und}$$
$$\vdots$$
$$U_{sn} = \lim_{T \to \infty} \frac{1}{T} \int_{-T/2}^{T/2} U_a(t) \sin n\omega_1 t dt.$$

Bei der Schaltung gemäss Fig. 3 ergibt sich die Verschiebung des im Umwandlungsblock 7 verarbeiteten Signals zum Gleichsignal bei der Bestimmung der Wirkleistung P und der Blindleistung Q des elektrischen Versorgungsnetzes ebenfalls durch R,S,T-dq-Transformation, bei der die bei der Netzfrequenz $\omega$ gemessenen Strom- und Spannungswerte der Phasen R,S,T in einem Referenz-Koordinatensystem betrachtet werden, welches mit der Nennkreisfrequenz $\omega_1$ des Versorgungsnetzes rotiert. Hierbei wird eine $\omega$-Komponente in eine $(\omega - \omega_1)$ - und $(\omega + \omega_1)$-Komponente aufgespalten, so dass für $\omega = \omega_1$ ein Gleichstromsignal resultiert. Bei der Schaltung gemäss Fig. 3 werden nun die den drei Phasen R,S,T zugeordneten Spannungen $U_a$, $U_b$ und $U_c$ im R,S,T-$\alpha,\beta$-Koordinatenwandler 153' zunächst in Referenzsignale $U \cdot \sin\omega_1 t$ und $U \cdot \cos\omega_1 t$ im mit Nennkreisfrequenz $\omega_1$ rotierenden $\alpha$ , $\beta$-Referenz-Koordinatensystem umgewandelt. Durch Eingabe der drei Phasenströme $I_a$, $I_b$ und $I_c$ und dieser Referenzsignale in den R,S,T-dq-Koordinatenwandler 153 erhält man schliesslich für $\omega = \omega_R = \omega_1$ am Ausgang von 153 für die direkte Koordinate zur Wirkleistung T und am Ausgang von 153 für die quadratische Komponente zur Blindleistung Q proportionale, ungefilterte Signale.

Bei der Schaltung gemäss Fig. 4 ergibt sich die Umwandlung des im Umwandlungsblock 7 verarbeiteten Signals zum Gleichsignal bei der Bestimmung der Netzfrequenz $\omega$ des Versorgungsnetzes dadurch, dass bei einer R,S,T-dq-Transformation im Koordinatenwandler 154 aus den Spannungssignalen $U_a$, $U_b$, $U_c$ eine quadratische Komponente q gewonnen wird, welche proportional zur Phasenwinkeldifferenz $\Delta\vartheta$ zwischen dem gemessenen Signal und dem Signal eines Referenzsystems ist, welches mit der Frequenz $\omega_R = \omega_1 + \Delta\omega$ rotiert:

$$q = A \cdot \sin\vartheta = A \cdot \Delta\vartheta .$$

Dieser Wert q beinhaltet ein Gleichstromsignal. Dieses Gleichstromsignal dient zur Regelung eines Phase-Locked-Loop, PLL. In diesem Phase-Locked-Loop wirkt der R,S,T,-dq-Koordinatenwandler 154 als Phasendetektor. Das am Ausgang des Phasendetektors für die quadratische Komponente anstehende Signal q wird dem als Filter des PLL dienenden PI-Regler 204 zugeführt. Am Ausgang des PI-Reglers 204 steht die Differenz $\Delta\omega$ zwischen der tatsächlichen Frequenz und der Nennkreisfrequenz $\omega_1$ an. Nach Addition der Nennkreisfrequenz $\omega_1$ zum Ausgangssignal $\Delta\omega$ des PI-Reglers 204 gelangt das hierbei gebildete Signal $\omega_R = \omega_1 + \Delta\omega$ in den als spannungsgeregelter Oszillator, VCO, des Phase-Locked-Loop, PLL, wirkenden Signalgenerator 194. Die Ausgangssignale $\sin\omega_R t$ und $\cos\omega_R t$ des Signalgenerators 194 werden dem R,S,T-dq-Koordinatenwandler 154 als Referenzsignale zugeführt.

Bei der Schaltung gemäss Fig. 5 ergibt sich die Umwandlung des im Umwandlungsblock 7 verarbeiteten Signals zum Gleichsignal bei der Bestimmung der Mitkomponente $I_+$ durch die Transformation eines R,S,T-dq-Koordinatenwandlers 155. Hierbei ergeben sich nämlich für die direkte Komponente $I_d$ und die quadratische Komponente $I_q$ folgende Werte:

$$I_d = I_+ \cos\phi_+ + I_- \cos(\phi_- + 2\omega_1 t)$$
$$I_q = I_+ \sin\phi_+ - I_- \sin(\phi_- + 2\omega_1 t).$$

$I_d$ und $I_q$ weisen daher jeweils einen Gleichstromanteil auf sowie einen nachfolgend in der Filteranordnung 8 entfernbaren Wechselstromanteil der Frequenz $2\omega_1$.

Bei der Koordinatentransformation durch den R,S,T-qd-Wandler 155' werden Signale $I_q$ und $I_d$ erhalten, welche lediglich einen von der Gegenkomponente $I_-$ abhängigen Gleichstromanteil enthalten.

Bei der Schaltung gemäss Fig. 6 ergibt sich die des im Umwandlungsblock 7 verarbeiteten Signals zum Gleichsignal bei der Bestimmung der Nullkomponente

$$I_o = 1/3 (I_a + I_b + I_c)$$

durch die Nachbildung der ein Gleichsignal liefernden Identität

$$i_o^2(t) + i_o^2(t+T_1/4)$$
$$= I_o^2 [\cos^2(\omega_1 t + \varphi_1) + \cos^2(\omega_1 t + \varphi_1 + \frac{\pi}{2})]$$
$$= I_o^2,$$

in einer das Verzögerungsglied 216, die beiden Multiplizierer 126 und 126' und den Summierer 166 enthaltenden Schaltung.

**Patentansprüche**

1. Digitales Messgerät zur Bestimmung der in einem oberwellenbehafteten elektrischen Versorgungsnetz auftretenden netzspezifischen Grössen durch Verarbeitung analoger, von mindestens einem Messfühler des Versorgungsnetzes abgegebener und aus der Grundwelle ($w_1$) sowie den Oberwellen ($w_i$, i = 2, 3, ,n) bestehender Messignale, enthaltend eine die analogen Messignale mit einer vorgegebenen Abtastfrequenz ($w_s$) abtastende und die abgetasteten Werte zwischenspeichernde Abtast- und Halte-Schaltung (4), einen der Abtast- und Halte-Schaltung (4) nachgeschalteten Analog-Digital-Wandler (5) zur Digitalisierung der abgetasteten und zwischengespeicherten Werte der Messsignale, und

eine mit dem Ausgang des Analog-Digital-Wandlers (5) verbundene digitale Verarbeitungseinheit (6) zur Bildung eines einer zu ermittelnden, netzspezifischen Grösse proportionalen Signals aus den zugeführten digitalisierten Werten der Messsignale,

dadurch gekennzeichnet, dass die digitale Verarbeitungseinheit (6) mindestens folgende Elemente enthält:

einen entsprechend jeder der zu bestimmenden netzspezifischen Grössen aufgebauten Block (7), in dem jedes der Messsignale zu einem Gleichsignal umgewandelt wird, und eine dem Umwandlungsblock (7) nachgeschaltete Filteranordnung (8) mit mindestens einem digitalen Tiefpass (100, 102,...) zum Unterdrücken von Signalen mit vom Gleichsignal abweichenden harmonischen Frequenzen sowie mindestens eine dem Tiefpass (100, 102,...) nachgeschaltete digitale Bandsperre (110, 112,...) zum Unterdrücken von Signalen mit Aliasfrequenzen.

2. Digitales Messgerät nach Anspruch 1, dadurch gekennzeichnet, dass der Umwandlungsblock (7) und die Filteranordnung (8) jeweils mindestens einen programmierbaren Funktionsblock aus einem Basissatz von voneinander unabhängigen, programmierbaren Funktionsblöcken enthalten.

3. Digitales Messgerät nach Anspruch 2, dadurch gekennzeichnet, dass die digitale Verarbeitungseinheit (6) eine der mindestens einen Filteranordnung (8) nachgeschaltete und mindestens einen der Funktionsblöcke enthaltende Vorrichtung zur Verarbeitung des von der mindestens einen Filteranordnung (8) abgegebenen Ausgangssignals aufweist.

4. Digitales Messgerät nach einem der Ansprüche 2 oder 3, dadurch gekennzeichnet, dass der Basissatz mindestens einen Summierer (162, 164, ...), einen Summierer mit Konstantfaktormultiplikation (182, 186), einen Multiplizierer (122, 122', ...), einen Dividierer (172, 175), einen Radizierer (142, 142', ...), einen Mittelwertbildner (132), einen PI-Regler (204), einen Koordinatenwandler (152, 153, ...), einen Signalgenerator (194) und einen Funktionsblock zur Berechnung einer Differenzengleichung zweiter Ordnung enthält.

5. Digitales Messgerät nach Anspruch 4, dadurch gekennzeichnet, dass der mindestens eine Tiefpass (100, 102, ...) und die mindestens eine Bandsperre (110, 112, ...) jeweils durch den eine Differenzengleichung zweiter Ordnung berechnenden Funktionsblock gebildet sind.

6. Digitales Messgerät nach einem der Ansprüche 4 oder 5, dadurch gekennzeichnet, dass zur Ermittlung des Effektivwerte ($U_{a,rms}$) des Stromes ($I_a$) oder der Spannung ($U_a$) einer Phase des Versorgungsnetzes der Umwandlungsblock (7) gebildet ist von einem als Ouadrierer wirkenden Multiplizierer (122), an dessen Eingang die digitalisierten Werte des Stromes oder der Spannung ($U_a$) anstehen und einem Mittelwertbildner (132), dessen Eingang mit dem Ausgang des Multiplizierers (122) verbunden ist und dessen Ausgang über die Filteranordnung (8) auf den Eingang eines Radizierers (142) der Verarbeitungseinheit (9) wirkt.

7. Digitales Messgerät nach einem der Ansprüche 4 oder 5, dadurch gekennzeichnet, dass zur Ermittlung des Effektivwertes ($U_n$) der n-ten Harmonischen des Stromes oder der Spannung einer Phase des Versorgungsnetzes der Umwandlungsblock (7) gebildet ist von einem R,S,T-dq-Koordinatenwandler (152), an dessen Eingängen die den drei Phasen des Versorgungsnetzes zugeordneten digitalisierten Signale der Spannung ($U_a$, $U_b$, $U_c$) anstehen sowie dem Sinus und Cosinus des Winkels zwischen dem R,S,T-Koordinatensystem und dem mit n-facher Nennkreisfrequenz ($\omega_1$) des Versorgungsnetzes rotierenden dq-Koordinantensystem zugeordnete Signale, und dessen Ausgang für die direkte Koordinate über einen ersten Tiefpass (102') und eine erste Bandsperre (112') der Filteranordnung (8) auf einen ersten als Quadrierer ausgebildeten Multiplizierer (122') wirkt, und dessen Ausgang für die quadratische Koordinate über einen zweiten Tiefpass (102'') und eine zweite Bandsperre (112'') der Filteranordnung (8) auf einen zweiten als Quadrierer ausgebildeten Multiplizierer (122'') wirkt, und dass die Ausgänge des ersten und des zweiten Multiplizierers (122', 122'') jeweils mit einem Eingang eines Summierers (162) verbunden sind, dessen Ausgang mit dem Eingang eines Radizierers (142') in Verbindung steht.

8. Digitales Messgerät nach den Ansprüchen 6 und 7, dadurch gekennzeichnet, dass zur Ermittlung des Klirrfaktors ($D_c$) die an den Eingängen der Radizierer (142, 142') anstehenden Signale jeweils einem von zwei Eingängen eines Dividierers (172) zugeführt werden, dessen Ausgang mit dem Eingang eines Summierers mit Konstantfaktormultiplikation (182) verbunden ist.

9. Digitales Messgerät nach einem der Ansprüche 4 oder 5, dadurch gekennzeichnet, dass zur Ermittlung der Wirkleistung (P) und der Blindleistung (Q) des Versorgungsnetzes ohne Nullkomponenten der Umwandlungsblock (7) gebildet ist von einem R,S,T-dq-Koordinatenwandler (153), an dessen Eingängen die den drei Phasen des Versorgungsnetzes zugeordneten digitalisierten Stromsignale ($I_a$, $I_b$, $I_c$) anliegen sowie Ausgangssignale eines R,S,T-$\alpha$,$\beta$-Koordinatenwandlers(153'), an dessen Eingängen die den drei Phasen des Versorgungsnetzes zugeordnete Spannungssignale ($U_a$, $U_b$, $U_c$) anliegen, und dessen Ausgang für die direkte Koordinate (P) über einen Tiefpass (103) und eine erste Bandsperre (113) auf einen ersten Ausgang der digitalen Verarbeitungseinheit (6) wirkt, und dessen Ausgang für die quadratische Koordinate (Q) über einen zweiten Tiefpass (103') und eine zweite Bandsperre (113') auf einen zweiten Ausgang der digitalen Verarbeitungseinheit (6) wirkt.

10. Digitales Messgerät nach einem der Ansprüche 4 oder 5, dadurch gekennzeichnet, dass zur Ermittlung der Netzfrequenz ($\omega$) des Versorgungsnetzes der Umwandlungsblock (7) als Phase-Locked-Loop ausgebildet ist.

11. Digitales Messgerät nach Anspruch 10, dadurch gekennzeichnet, dass der Phase-Locke-Loop als Phasendetektor einen R,S,T-dq-Koordinatenwandler (154) aufweist, an dessen Eingängen den drei Phasen des Versorgungsnetzes zugeordnete Signale anliegen sowie Ausgangssignale eines als VCO wirkenden Signalgenerators (194) und dessen Ausgang für die quadratische Koordinate dem Eingang eines als Schleifenfilter wirkenden PI-Reglers (204) zugeführt ist, dessen Ausgang einerseits mit dem Eingang des Tiefpasses (104) der Filteranordnung (8) verbunden ist und andererseits mit einem ersten Eingang eines auf den Signalgenerator (194) wirkenden Summierers (164), an dessen zweiten Eingang ein der Nennkreisfrequenz ($\omega_1$) des Versorgungsnetzes proportionales Signal ansteht.

12. Digitales Messgerät nach einem Ansprüche 4 oder 5, dadurch gekennzeichnet, dass zur Ermittlung der Mitkomponente ($I_+$) der Umwandlungsblock (7) gebildet ist von einem R,S,T-dq-Koordinatenwandler (155), an dessen Eingängen die den drei Phasen des Versorgungsnetzes zugeordneten digitalisierten Signale des Stromes anstehen sowie dem Sinus und Cosinus eines zeitveränderlichen Winkels zwischen dem R,S,T- und dem dq-Koordinatensystem zugeordnete Signale, und dessen Ausgang für die direkte Koordinate über einen ersten Tiefpass (105) und eine erste Bandsperre (115) der Filteranordnung (8) auf einen ersten als Quadrierer ausgebildeten Multiplizierer (125) wirkt und dessen Ausgang für die quadratische Koordinate über einen zweiten Tiefpass (105') und eine zweite Bandsperre (115') der Filteranordnung (8) auf einen zweiten als Quadrierer ausgebildeten Multiplizierer (125') wirkt, und dass die Ausgänge des ersten und des zweiten Multiplizierers (125, 125') jeweils mit einem Eingang eines Summierers (165) verbunden sind, dessen Ausgang mit dem Eingang eines Radizierers (145) in Verbindung steht.

13. Digitales Messgerät nach einem der Ansprüche 4 oder 5, dadurch gekennzeichnet, dass zur Ermittlung der Gegenkomponente ($I_-$) der Umwandlungsblock (7) gebildet ist von einem R,S,T-qd-Koordinatenwandler (155') an dessen Eingängen die den drei Phasen des Versorgungsnetzes zugeordnete digitalisierte Signal des Stromes anstehen sowie dem Cosinus und Sinus eines zeitveränderlichen Winkels zwischen dem R,S,T- und dem qd-Koordinatensystem zugeordnete Signale, und dessen Ausgang für die quadratische Koordinate über einen ersten Tiefpass (105'')und eine erste Bandsperre (115'') der Filteranordnung (8) auf einen ersten als Quadrierer ausgebildeten Multiplizierer (125'') wirkt und dessen Ausgang für die direkte Koordinate über einen zweiten Tiefpass (105''') und eine zweite Bandsperre (115''') der Filteranordnung (8) auf einen zweiten als Quadrierer ausgebildeten Mutliplizierer (125''') wirkt, und dass die Ausgänge des ersten und des zweiten Multiplizierers (125'', 125''') jeweils mit einem Eingang eines Summierers (165')verbunden sind, dessen Ausgang mit dem Eingang eines Radizierers (145') in Verbindung steht.

14. Digitales Messgerät nach den Ansprüchen 12 und 13, dadurch gekennzeichnet, dass zur Ermittlung des Asymmetrieverhältnisses ($I_-/I_+$) die Ausgänge der Radizierer (145, 145') jeweils mit einem von zwei Eingängen eines Dividierers (175) verbunden sind.

**15.** Digitales Messgerät nach einem der Ansprüche 4 oder 5, dadurch gekennzeichnet, dass zur Ermittlung der Nullkomponente ($I_o$) der Umwandlungsblock (7) von einer Schaltungsanordnung gebildet ist, mit einem Summierer mit Konstantfaktormultiplikation (186), einem ersten und einem zweiten jeweils als Quadrierer ausgebildeten Multiplizierer (126, 126'), einem Verzögerungsglied (216) mit einer Zeitverzögerung von einem 1/4 der Periode ($T_1$) des Versorgungsnetzes und einem Summierer (166), bei der dem Eingang des Summierers mit Konstantfaktormultiplikation (186) den Phasenströmen des Versorgungsnetzes zugeordnete digitalisierte Signale zugeführt sind, der Ausgang des Summierers mit Konstantfaktormultiplikation (186) einerseits mit dem Eingang des ersten Multiplizierers (126') und andererseits über das Verzögerungsglied (216) auf den Eingang des zweiten Multiplizierers (216) wirkt und bei der die Ausgänge des ersten und zweiten Multiplizierers (126, 126') auf den Summierer (166) wirken.

**Claims**

**1.** Digital measuring instrument for determining the system-specific quantities occurring in an electrical supply system containing harmonics by processing analog measurement signals emitted by at least one sensor of the electrical supply system and consisting of the fundamental wave ($w_1$) and the harmonics ($w_i$, i = 2, 3, , n), containing

a sample and hold circuit (4) which samples the analog measurement signals at a predetermined sampling rate ($w_s$) and temporarily stores the sampled values,

an analog/digital converter (5) which follows the sample and hold circuit (4), for digitizing the sampled and temporarily stored values of the measurement signals, and digital processing unit (6), which is connected to the output of the analog/digital converter (5), for forming a signal proportional to a system-specific quantity to be determined from the digitized values of the measurement signals supplied, characterized in that the digital processing unit (6) contains at least the following elements:

a block (7) constructed in accordance with each of the system-specific quantities to be determined, in which each of the measurement signals is converted to a direct-current signal, and a filter arrangement (8), which follows the conversion block (7), with at least one digital low-pass filter (100, 102, ...) for suppressing signals with harmonic frequencies deviating from the direct current signal and with at least one digital band stop filter (110, 112, ...) following the low-pass filter (100, 102, ...) for suppressing signals with aliasing frequencies.

**2.** Digital measuring instrument according to Claim 1, characterized in that the conversion block (7) and the filter arrangement (8) contain in each case at least one programmable function block of a basic set of mutually independent programmable function blocks.

**3.** Digital measuring instrument according to Claim 2, characterized in that the digital processing unit (6) exhibits a device, following the at least one filter arrangement (8) and containing at least one of the function blocks, for processing the output signal emitted by the at least one filter arrangement (8).

**4.** Digital measuring instrument according to either of Claims 2 or 3, characterized in that the basic set contains at least one summing unit (162, 164, ...), one summing unit with constant factor multiplication (182, 186), one multiplier (122, 122', ...), one divider (172, 175), one root extractor (142, 142', ...), one averaging unit (132), one PI controller (204), one coordinate converter (152, 153, ...), one signal generator (194) and one function block for calculating a secondorder differential equation.

**5.** Digital measuring instrument according to Claim 4, characterized in that the at least one low-pass filter (100, 102, ...) and the at least one band stop filter (110, 112, ...) are in each case formed by the function block calculating a second order differential equation.

**6.** Digital measuring instrument according to either of Claims 4 or 5, characterized in that, for the determination of the root mean square value ($U_{a,rms}$) of the current ($I_a$) or of the voltage ($U_a$) of a phase of the supply system, the conversion block (7) is formed by a multiplier (122) which acts as squaring unit and at the input of which the digitized values of the current or of the voltage ($U_a$) are present, and an averaging unit (132) the input of which is connected to the output of the multiplier (122) and the output of which acts via the filter arrangement (8) on the input of a root extractor (142) of the processing unit (9).

7. Digital measuring instrument according to either of Claims 4 or 5, characterized in that, for determining the root mean square value ($U_n$) of the n-th harmonic of the current or of the voltage of a phase of the supply system, the conversion block (7) is formed by an R,S,T/dq coordinate converter (152) at the inputs of which the digitized signals of the voltage ($U_a$, $U_b$, $U_c$) allocated to the three phases of the supply system are present and signals allocated to the sine and cosine of the angle between the R,S,T coordinate system and the dq coordinate system rotating with n-times the nominal angular frequency ($\omega_1$) of the supply system, and the output of which for the direct coordinate acts via a first low-pass filter (102') and a first band stop filter (112') of the filter arrangement (8) on a first multiplier (122') constructed as squaring unit and the output of which for the quadratic coordinate acts via a second low-pass filter (102'') and a second band stop filter (112'') of the filter arrangement (8) on a second multiplier (122'') constructed as squaring unit, and the outputs of the first and of the second multiplier (122', 122'') are in each case connected to an input of a summing unit (162), the output of which is connected to the input of a root extractor (142').

8. Digital measuring instrument according to Claims 6 and 7, characterized in that, for the determination of the total harmonic distortion ($D_c$), the signals present at the inputs of the root extractor (142, 142') are in each case supplied to one of two inputs of a divider (172) the output of which is connected to the input of a summing unit with constant factor mutiplication (182).

9. Digital measuring instrument according to one of Claims 4 or 5, characterized in that for the determination of the active power (P) and of the reactive power (Q) of the supply system without zero-sequence components, the conversion block (7) is formed by an R,S,T/dq coordinate converter (153) at the inputs of which the digitized current signals ($I_a$, $I_b$, $I_c$) allocated to the three phases of the supply system are present and output signals of an R,S,T,$\alpha,\beta$ coordinate converter (153') at the inputs of which the voltage signals ($U_a$, $U_b$, $U_c$) allocated to the three phases of the supply system are present and the output of which for the direct coordinate (P) acts via a low-pass filter (103) and a first band-stop filter (113) on a first output of the digital processing unit (6) and the output of which for the quadratic coordinate (Q) acts via a second low-pass filter (103') and a second band-stop filter (113') on a second output of the digital processing unit (6).

10. Digital measuring instrument according to either of Claims 4 or 5, characterized in that the conversion block (7) is constructed as phase-locked loop for determination of the system frequency ($\omega$) of the supply system.

11. Digital measuring instrument according to Claim 10, characterized in that the phase-locked loop, as phase detector, exhibits an R,S,T/dq coordinate converter (154) at the inputs of which signals allocated to the three phases of the supply system are present and output signals of a signal generator (194) acting as VCO and the output of which for the quadratic coordinate is supplied to the input of a PI controller (204) acting as loop filter, the output of which is connected, on the one hand, to the input of the low-pass filter (104) of the filter arrangement (8) and, on the other hand, to a first input of a summing unit (164) acting on the signal generator (194), at the second input of which a signal proportional to the nominal angular frequency ($\omega_1$) of the supply system is present.

12. Digital measuring instrument according to one of [lacuna] Claims 4 or 5, characterized in that, for the determination of the positive-sequence component ($I_+$), the conversion block (7) is formed by an R,S,T/dq coordinate converter (155) at the inputs of which the digitized signals of the current allocated to the three phases of the supply system are present and signals allocated to the sine and cosine of a time-variable angle between the R,S,T system and the dq system of coordinates and the output of which for the direct coordinate acts via a first low-pass filter (105) and a first band-stop filter (115) of the filter arrangement (8) on a first multiplier (125) constructed as squaring unit and the output of which for the quadratic coordinate acts via a second low-pass filter (105') and a second band-stop filter (115') of the filter arrangement (8) on a second multiplier (125') constructed as squaring unit and the outputs of the first and second multiplier (125, 125') are each connected to an input of a summing unit (165) the output of which is connected to the input of a root extractor (145).

13. Digital measuring instrument according to one of Claims 4 or 5, characterized in that, for the determination of the negative-sequence component ($I_-$), the conversion block (7) is formed by an R,S,T/qd coordinate converter (155') at the inputs of which the digitized signals of the current allocated to the three phases of the supply system are present and signals allocated to the cosine and sine of a time-variable angle between the R,S,T system and the qd system of coordinates and the output of which for the quadratic coordinate acts via a first low-pass filter (105'') and a first band-stop filter (115'') of the filter arrangement (8) on a first multiplier (125'') constructed as squaring unit and the output of which for the direct coordinate acts via a second low-pass filter (105''') and a second band-stop filter (115''') of the filter arrangement (8) on a second multiplier (125''') constructed as squaring unit, and the outputs of the first and of the second multiplier (125'', 125''') are in each case connected to an input of a summing unit (165') the output of which is connected to the input of a root extractor (145').

14. Digital measuring instrument according to Claims 12 and 13, characterized in that, for the determination of the ratio of imbalance (I$_-$/I$_+$), the outputs of the root extractor (145, 145') are in each case connected to one of two inputs of a divider (175).

15. Digital measuring instrument according to one of Claims 4 or 5, characterized in that, for the determination of the zero-sequence component (I$_o$), the conversion block (7) is formed by a circuit arrangement with a summing unit with constant factor multiplication (186), a first and a second multiplier (126, 126') constructed in each case as squaring unit, a delay section (216) with a time delay of $\frac{1}{4}$ of the period (T$_1$) of the supply system and a summing unit (166), in which digitized signals allocated to the phase currents of the supply system are supplied to the input of the summing unit with constant factor multiplication (186), the output of the summing unit with constant factor multiplication (186) [lacuna], on the one hand, to the input of the first multiplier (126') and, on the other hand, acts via the delay section (216) on the input of the second multiplier (126) and in which the outputs of the first and second multiplier (126, 126') act on the summing unit (166).

**Revendications**

1. Appareil de mesure numérique pour la détermination des grandeurs spécifiques au réseau apparaissant dans un réseau d'alimentation électrique à harmoniques par traitement de signaux de mesure analogiques fournis par au moins un capteur de mesure du réseau d'alimentation et constitués de l'onde fondamentale ($\omega_1$) ainsi que des harmoniques ($\omega_i$, i = 2, 3, ..., n), contenant :
   un circuit échantillonneur-bloqueur (4) échantilllonnant les signaux de mesure analogiques avec une fréquence d'échantillonnage prédéterminée ($\omega_s$) et plaçant les valeurs échantillonnées, en mémoire tampon,
   un convertisseur analogique/numérique (5) monté en aval du circuit échantillonneur-bloqueur (4) pour numériser les valeurs échantillonnées et placées en mémoire tampon des signaux de mesure, et
   une unité de traitement numérique (6) connectée à la sortie du convertisseur analogique/numérique (5) pour former un signal proportionnel à une grandeur spécifique au réseau à déterminer à partir des valeurs numérisées acheminées des signaux de mesure,
   caractérisé en ce que l'unité de traitement numérique (6) contient au moins les élément suivants :
   un bloc (7) conçu d'une manière correspondant à chacune des grandeurs spécifiques au réseau à déterminer, bloc dans lequel chacun des signaux de mesure est converti en un signal continu, et un montage de filtrage (8) monté en aval du bloc de conversion (7) avec au moins un filtre passe-bas numérique (100, 102, ...) pour supprimer les signaux à fréquences harmoniques s'écartant du signal continu ainsi qu'au moins un filtre coupe-bande numérique (110, 112, ...) monté en aval du filtre passe-bas (100, 102, ...) pour supprimer des signaux à fréquences de repliement.

2. Appareil de mesure numérique selon la revendication 1, caractérisé en ce que le bloc de conversion (7) et le montage de filtrage (8) contiennent chacun au moins un bloc fonctionnel programmable constitué d'un jeu de base de blocs fonctionnels programmables indépendants les uns des autres.

3. Appareil de mesure numérique selon la revendication 2, caractérisé en ce que l'unité de traitement numérique (6) comporte un dispositif pour le traitement du signal de sortie fourni par le montage de filtrage (8), monté en aval du montage de filtrage (8) et contenant au moins un des blocs fonctionnels.

4. Appareil de mesure numérique selon la revendication 2 ou 3, caractérisé en ce que le jeu de base contient au moins un sommateur (162, 164, ...), un sommateur à multiplication par facteur constant (182, 186), un multiplicateur (122, 122' ...), un diviseur (172, 175), un extracteur de racines (142, 142',...), un formateur de valeurs moyennes (132), un régulateur PI (204), un convertisseur de coordonnées (152, 153, ...), un générateur de signaux (194) et un bloc fonctionnel pour calculer une équation différentielle du second degré.

5. Appareil de mesure numérique selon la revendication 4, caractérisé en ce que ledit au moins un le filtre passe-bas (100, 102, ...) et ledit au moins un filtre coupe-bande (110, 112,...)sont formés chacun par le bloc fonctionnel calculant une équation différentielle du second degré.

6. Appareil de mesure numérique selon la revendication 4 ou 5, caractérisé en ce que, pour obtenir la valeur efficace ($U_{a,rms}$) du courant ($I_a$) ou de la tension ($U_a$) d'une phase du réseau d'alimentation, le bloc de conversion (7) est formé d'un multiplicateur (122) jouant le rôle d'élévateur au carré, à l'entrée duquel apparaissent les valeurs numérisées du courant ou de la tension ($U_a$), et d'un formateur de valeurs moyennes (132), dont l'entrée est connectée à la sortie du multiplicateur (122) et dont la sortie agit, via le montage de filtrage (8), sur l'entrée d'un extracteur de racines (142) de l'unité de traitement (9).

7. Appareil de mesure numérique selon la revendication 4 ou 5, caractérisé en ce que, pour obtenir la valeur efficace ($U_n$) du nième harmonique du courant ou de la tension d'une phase du réseau d'alimentation, le bloc de conversion (7) est formé d'un convertisseur de coordonnées R,S,T-dq (152) aux entrées duquel apparaissent les signaux numérisés de la tension ($U_a$, $U_b$, $U_c$) affectés aux trois phases du réseau d'alimentation ainsi que les signaux affectés au sinus et au cosinus de l'angle entre le système de coordonnées R,S,T et le système de coordonnées dq tournant avec n fois la fréquence angulaire nominale ($\omega_1$) du réseau d'alimentation, et dont la sortie pour la coordonnée directe agit via un premier filtre passe-bas (102') et un premier filtre coupe-bande (112') du montage de filtrage (8) sur un premier multiplicateur (122') ayant la forme d'un éleveur au carré, et la sortie pour la coordonnée quadratique agit via un second filtre passe-bas (102'') et un second filtre coupe-bande (112'') du montage de filtrage (8) sur un second multiplicateur (122'') ayant la forme d'un élévateur au carré, et les sorties du premier et du second multiplicateur (122', 122'') sont connectées chacune à une entrée d'un sommateur (162), dont la sortie est en liaison avec l'entrée d'un extracteur de racines (142').

8. Appareil de mesure numérique selon les revendications 6 et 7, caractérisé en ce que, pour détermine le facteur de distorsion ($D_c$), les signaux apparaissant aux entrées des extracteurs de racines (142, 142') sont acheminés chacun à l'une des deux entrées d'un diviseur (172), dont la sortie est connectée à l'entrée d'un sommateur à multiplication par facteur constant (182).

9. Appareil de mesure numérique selon la revendication 4 ou 5, caractérisé en ce que, pour déterminer la puissance réelle (P) et la puissance apparente (Q) du réseau d'alimentation sans composantes homopolaires, le bloc de conversion (7) est formé d'un convertisseur de coordonnées R,S,T-dq (153), aux entrées duquel sont appliqués les signaux de courant ($I_a$, $I_b$, $I_c$) numérisés affectés aux trois phases du réseau d'alimentation ainsi que les signaux de sortie d'un convertisseur de coordonnées R,S,T-$\alpha$,$\beta$ - (153') aux entrées duquel s'appliquent les signaux de tension ($U_a$, $U_b$, $U_c$) affectés aux trois phases du réseau d'alimentation, et dont la sortie pour la coordonnée directe (P) agit, via un filtre passe-bas (103) et un premier filtre coupe-bande (113), sur une première sortie de l'unité de traitement numérique (6), et la sortie pour la coordonnée quadratique (Q) agit via un second filtre passe-bas (103') et un second filtre coupe-bande (113') sur une seconde sortie de l'unité de traitement numérique (6).

10. Appareil de mesure numérique selon la revendication 4 ou 5, caractérisé en ce que, pour obtenir la fréquence ($\omega$) du réseau d'alimentation, le bloc de conversion (7) a la forme d'une Phase/Locked-Loop.

11. Appareil de mesure numérique selon la revendication 10, caractérisé en ce que la Phase-Locked-Loop comporte à titre de détecteur de phase un convertisseur de coordonnées R,S,T-dq (154) aux entrées duquel s'appliquent les signaux affectés aux trois phases du réseau d'alimentation ainsi que les signaux de sortie d'un générateur de signaux (194) jouant le rôle de VCO et dont la sortie pour la coordonnée quadratique est acheminée à l'entrée d'un régulateur PI (204) jouant le rôle de filtre à boucle, dont la sortie est connectée d'une part à l'entrée du filtre passe-bas (104) du montage de filtrage (8) et d'autre part à une première entrée d'un sommateur (164) agissant sur le générateur de signaux (194), à la seconde entrée duquel s'applique un signal proportionnel à la fréquence angulaire nominale ($\omega_1$) du réseau d'alimentation.

16

**12.** Appareil de mesure numérique selon la revendication 4 ou 5, caractérisé en ce que, pour déterminer la composante directe (I+), le bloc de conversion (7) est formé d'un convertisseur de coordonnées R,S,T-dq (155) aux entrées duquel apparaissent les signaux de courant numérisés affectés aux trois phases du réseau d'alimentation ainsi que les signaux affectés au sinus et au cosinus d'un angle variable dans le temps entre le système de coordonnées R,S,T et le système de coordonnées dq, et dont la sortie pour la coordonnée directe agit via un premier filtre passe-bas (105) et un premier filtre coupe-bande (115) du montage de filtrage (8) sur un premier multiplicateur (125) ayant la forme d'un élevateur au carré et la sortie pour la coordonnée quadratique agit, via un second filtre passe-bas (105') et un second filtre cooupe-bande (115') du montage de filtrage (8), sur un second multiplicateur (125') qui a la forme d'un élevateur au carré, et les sorties du premier et du second multiplicateur (125, 125') sont connectées chacune à une entrée d'un sommateur (165), dont la sortie est en liaison avec l'entrée d'un extracteur de racines (145).

**13.** Appareil de mesure numérique selon la revendication 4 ou 5, caractérisé en ce que, pour déterminer la compasante inverse (I−), le bloc de conversion (7) est formé d'un premier convertisseur de coordonnées R,S,T-qd (155') aux entrées duquel s'appliquent le signal de courant numérisé aftecté aux trois phases du réseau d'alimentation ainsi que les signaux affectés aux cosinus et sinus d'un angle variable dans le temps entre le système de coordonnées R,S,T et le système de coordonnées qd, et dont la sortie pour la coordonnée quadratique agit via un premier filtre passe-bas (105'') et un premier filtre coupe-bande (115'') du montage de filtrage (8), sur un premier multiplicateur (125'') ayant la forme d'un élévateur au carré et la sortie pour la coordonnée directe agit, via un second filtre passe-bas (105''') et un second filtre coupe-bande (115''') du montage de filtrage (8), sur un second multiplicateur (125''') qui a la forme d'un élévateur au carré, et les sorties du premier et du second multiplicateur (125'', 125''') sont connectées chacune à une entrée d'un sommateur (165'), dont la sortie est en liaison avec l'entrée d'un extracteur de racines (145').

**14.** Appareil de mesure numérique selon les revendications 12 et 13, caractérisé en ce que, pour déterminer le rapport d'asymétrie (I−/I+), les sorties des extracteurs de racines (145, 145') sont chacune connectées à une des deux entrées d'un diviseur (175).

**15.** Appareil de mesure numérique selon la revendication 4 ou 5, caractérisé en ce que, pour déterminer la composante homopolaire (I₀), le bloc de conversion (7) est formé d'un circuit comportant un sommateur à multiplication par facteur constant (186) un premier et un second multiplicateurs (126, 126') ayant chacune la forme d'un élevateur au carré, un élément de temporisation (216) avec un retard de 1/4 de la période (T₁) du réseau d'alimentation et un sommateur (166), dans lequel sont acheminés, à l'entrée du sommateur à multiplication par facteur constant (186), les signaux numérisés affectés au courants de phase du réseau d'alimentation, la sortie du sommateur à multiplication par facteur constant (186) agissant, d'une part, sur l'entrée du premier multiplicateur (126') et d'autre part via l'élément de temporisation (216), sur l'entrée du second multiplicateur (126) et dans lequel les sorties du premier et du second multiplicateur (126, 126') agissent sur le sommateur (166).

FIG.1

EP 0 269 827 B1

FIG.2

FIG.3

FIG.4

EP 0 269 827 B1

FIG.5

FIG.6

21